# FASCICULE DE BREVET EUROPEEN

(11) **EP 2 866 538 B1**
(45) Date de publication et mention de la délivrance du brevet: **13.03.2019**
(21) Numéro de dépôt: 14190670.1
(22) Date de dépôt: 28.10.2014
(51) Int. Cl.: H05K 7/14, H05K 7/20, H05K 1/02

(54) **Verrouillage d'une carte électronique**
Verriegelungsvorrichtung für eine Leiterplatte
Locking mechanism for a printed circuit board

(30) Priorité: 28.10.2013 FR 1359425
(43) Date de publication de la demande: 29.04.2015
(73) Titulaire: Kontron Modular Computers SAS, 83078 Toulon Cedex 9 (FR)
(72) Inventeur: Tissot, Serge, 83400 Hyeres (FR); Mollard, Emmanuel, 83260 La Crau (FR); Collin, Yannick, 83400 Hyeres (FR)
(74) Mandataire: Collet, Alain

(56) Documents cités:
- EP-A2- 1 853 097
- EP-A2- 2 395 827

## Description

L'invention se situe dans le domaine électronique et concerne le verrouillage d'une carte électronique équipée d'un drain thermique.

On appellera circuit imprimé un circuit imprimé nu, c'est-à-dire sans composants et carte électronique un circuit imprimé équipé de composants et éventuellement d'un drain thermique. Un circuit imprimé est constitué d'un assemblage d'une ou plusieurs couches conductrices séparées par un matériau isolant. Les couches sont gravées pour obtenir un ensemble de pistes.

Traditionnellement, les calculateurs modulaires sont composés de cartes électroniques assemblées et maintenues dans un châssis au niveau de glissières perpendiculaires au fond de panier. Les cartes électroniques sont parallèles entre elles. Une carte électronique dispose de composants. En fonctionnement, les composants de la carte électronique peuvent dissiper une grande quantité de chaleur. Cette chaleur doit être évacuée afin de maintenir une température de fonctionnement adéquate.

Il existe deux grandes classes de refroidissement : le refroidissement par convection thermique et le refroidissement par conduction thermique.

La convection thermique consiste à mettre un corps chaud en contact avec un fluide. Une partie de l'énergie thermique du corps chaud est transférée au fluide. Dans le domaine de l'électronique, le refroidissement par convection thermique se fait généralement avec un fluide gazeux, par exemple l'air. Pour une meilleure convection, il est possible de forcer la circulation du fluide. Par exemple, des ventilateurs peuvent être utilisés afin d'augmenter la circulation d'air au niveau des composants chauds de la carte électronique. L'échange thermique entre les composants chauds et l'air est ainsi amélioré.

La conduction thermique est un mode de transfert thermique résultant d'une différence de température entre deux zones d'un même milieu ou entre deux milieux différents en contact. Le refroidissement par conduction thermique est parfois préféré au refroidissement par convection dans les environnements sévères, notamment pour des raisons de fiabilité (aucune pièce mobile telle qu'un ventilateur) et d'étanchéité aux contaminants (poussières, ...).. La conduction thermique est l'un des modes de refroidissement choisi pour les calculateurs modulaires embarqués.

Dans une carte électronique, le refroidissement par conduction thermique se fait grâce à un drain thermique. Le drain thermique est formé d'une plaque qui peut par exemple être en cuivre, en aluminium ou en matériaux composites. Le drain thermique peut être disposé au dessus de la carte électronique parallèlement au plan du circuit imprimé. Il épouse la forme des composants de la carte. Deux moyens de verrouillage appelés wedgelocks ou cardlocks dans la littérature anglo-saxonne sont positionnés le long des deux bords de la carte perpendiculaires au fond de panier pour serrer la carte électronique et son drain thermique dans un châssis. Le moyen de verrouillage est un moyen de verrouillage expansible qui presse le drain thermique contre une glissière du châssis. Le châssis représente le milieu froid. Le drain thermique permet l'évacuation de la chaleur par conduction entre les composants chauds de la carte et le châssis. La pression du drain thermique contre le milieu froid assure un bon contact et donc un bon échange thermique. Par exemple, le brevet EP 2 395 827 décrit une carte électronique comprenant notamment un circuit imprimé et un drain thermique fixé au circuit par des vis. Un moyen de verrouillage est placé dans la glissière du châssis entre le châssis et le drain. Le brevet EP 1 853 097 décrit un wedgelock permettant le serrage d'un drain thermique contre des faces d'un châssis dans le but d'obtenir plusieurs chemins thermiques afin d'évacuer la chaleur produite par un circuit imprimé sur lequel le drain thermique est fixé.

Actuellement, pour une version de carte en mode de refroidissement par conduction, le verrouillage de la carte électronique avec son drain thermique se faisant à l'aide d'un moyen de verrouillage standard, il est nécessaire de découper les bords du circuit imprimé. Cette découpe a de nombreux inconvénients. En effet, selon le mode de refroidissement, convection ou conduction, il faut prévoir deux formats de circuit imprimé. Cela nécessite donc la fabrication et le stockage de deux formats différents de circuits imprimés. De plus, pour passer d'un circuit imprimé en refroidissement par convection à un circuit imprimé en refroidissement par conduction, il faut réaliser une découpe du circuit imprimé. La découpe d'un circuit imprimé est un procédé délicat. Il faut respecter les tolérances de découpe par rapport aux pistes de cuivre, et il y a un risque de diffusion de résidus de découpe sur toute la carte électronique. Enfin, en vue d'une possible découpe du circuit imprimé en cas de refroidissement par conduction, cette partie de la carte n'est pas envisageable pour le positionnement de pistes ou de composants.

Un but de l'invention est de disposer d'un circuit imprimé unique compatible d'un refroidissement par convection et par conduction, sans devoir procéder à une redécoupe de la carte pour convertir une carte assemblée avec ses composants électroniques du mode refroidissement par convection au mode refroidissement par conduction. Un autre but de l'invention est d'augmenter les dimensions d'un circuit imprimé utilisé dans une carte électronique équipée d'un drain thermique pour se rapprocher du format d'un circuit imprimé utilisé dans une carte électronique sans drain et refroidie par convection.

A cet effet, l'invention a pour objet une carte électronique comprenant :
- un circuit imprimé plan,
- un drain thermique positionné sur le circuit imprimé parallèlement au circuit imprimé,
- un moyen de verrouillage expansible positionné le long d'un bord du circuit imprimé comprenant une partie de transmission de mouvement et une partie mobile en translation selon un axe incluant une composante perpendiculaire au circuit imprimé, la partie mobile en translation disposant d'au moins un évidement s'ouvrant sur une face du moyen de verrouillage expansible perpendiculaire au circuit imprimé,
le moyen de verrouillage étant destiné à immobiliser la carte dans un châssis et à presser le drain thermique contre une face du châssis,
caractérisé en ce que le circuit imprimé comprend une zone qui entre dans le ou les évidements du moyen de verrouillage expansible.

L'invention sera mieux comprise et d'autres avantages apparaîtront à la lecture de la description détaillée d'un mode de réalisation donné à titre d'exemple, description illustrée par le dessin joint dans lequel :
- la figure 1 représente un châssis recevant une carte électronique assemblée ;
- la figure 2 représente deux formats de circuit imprimé selon le mode de refroidissement mis en oeuvre ;
- la figure 3 représente en coupe un assemblage d'une carte électronique avec son drain thermique et son moyen de verrouillage ;
- les figures 4a, 4b et 4c représentent en coupe un assemblage d'une carte électronique avec son drain thermique et son moyen de verrouillage selon l'invention ;
- la figure 5 représente le positionnement du circuit imprimé et du drain thermique par rapport au moyen de verrouillage selon l'invention ;
- la figure 6 représente en coupe un assemblage d'une carte électronique avec son drain thermique, son moyen de verrouillage et un drain secondaire selon l'invention ;
- la figure 7 représente le circuit imprimé selon l'invention.

Par souci de clarté, les mêmes éléments porteront les mêmes repères dans les différentes figures.

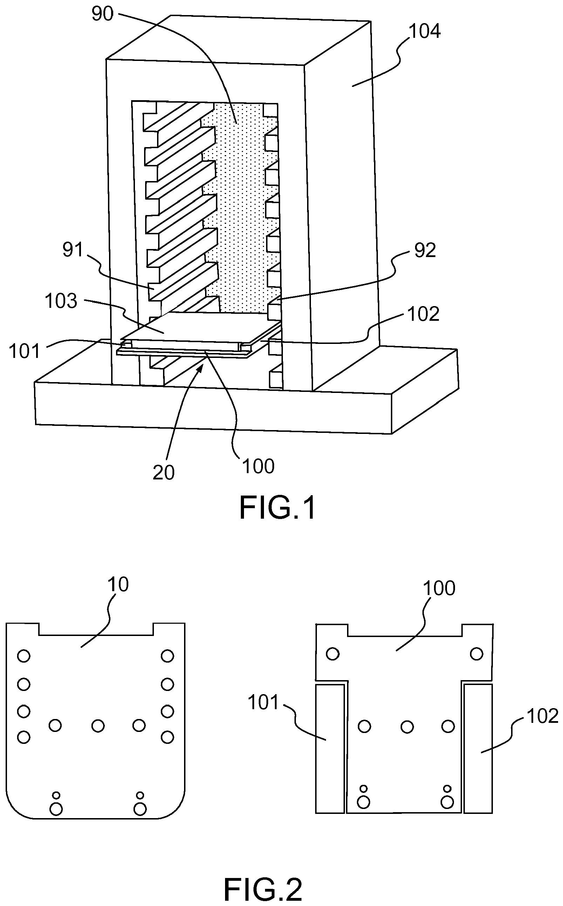

La figure 1 représente un châssis 104 recevant une carte électronique 20 d'un assemblage principalement refroidi par conduction. La carte électronique 20 est composée d'un circuit imprimé 100. La carte électronique 20 est maintenue dans le châssis 104 au niveau de glissières 91 et 92 perpendiculaires à un fond de panier 90. Le refroidissement par conduction thermique se fait grâce à un drain thermique 103 disposé au dessus de la carte électronique 20 parallèlement au circuit imprimé 100. Deux moyens de verrouillage expansibles 101 et 102, aussi appelés wedgelocks ou cardlocks, sont positionnés le long des deux bords du circuit imprimé 100 perpendiculaires au fond de panier pour serrer la carte électronique 20 et le drain thermique 103. Le moyen de verrouillage expansible 101 presse le drain thermique 103 contre la glissière 91 du châssis 104. De même, le moyen de verrouillage expansible 102 presse le drain thermique 103 contre la glissière 92 du châssis 104.

La figure 2 représente deux formats de circuit imprimé selon les deux modes de refroidissement par convection et par conduction. Un circuit imprimé 10 est conçu pour être refroidi principalement par convection. Le circuit imprimé 100 est conçu pour être refroidi principalement par conduction. Le circuit imprimé 100 diffère du circuit imprimé 10 en ce que les bords perpendiculaires au fond de panier 90 ont été découpés afin de permettre le positionnement des moyens de verrouillage expansibles 101 et 102 le long des deux bords du circuit imprimé perpendiculaires au fond de panier 90 pour verrouiller le circuit imprimé 100 et le drain thermique 103.

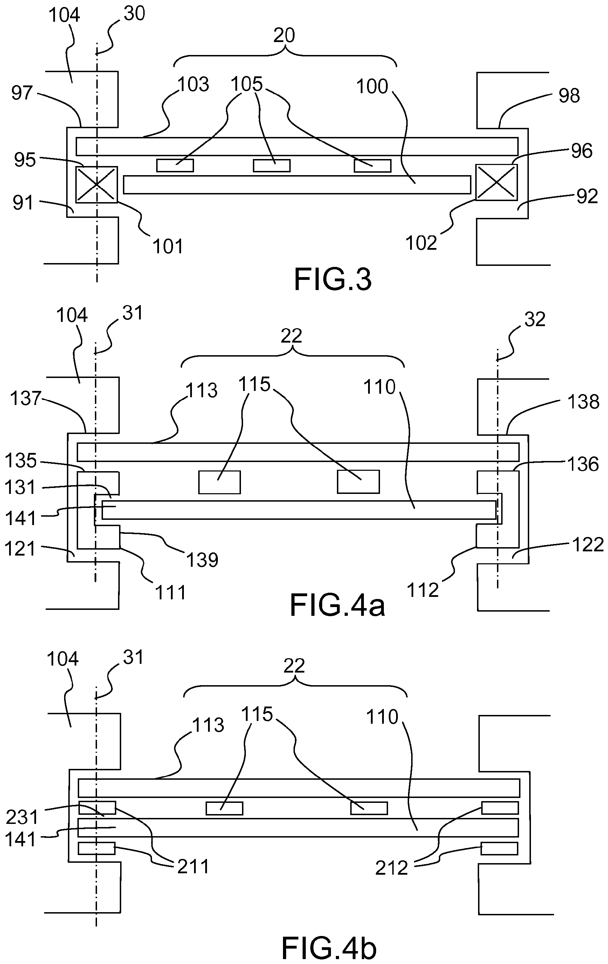

La figure 3 représente en coupe dans un plan perpendiculaire au circuit imprimé 100 et parallèle au fond de panier un exemple d'assemblage standard de la carte électronique 20 comprenant le circuit imprimé 100, le drain thermique 103 et les moyens de verrouillage expansibles 101 et 102 pour un refroidissement par conduction. La carte électronique 20 dispose de composants 105. Le drain thermique 103 est superposé et parallèle au circuit imprimé 100 et épouse la forme des composants 105. Il s'agit d'un exemple d'assemblage. Un assemblage alternatif consiste en un drain thermique disposé entre le circuit imprimé et les composants.

Chacun des moyens de verrouillage expansibles 101 et 102 comprend une partie mobile parallèlement au circuit imprimé 100 et une partie mobile en translation selon un axe 30 incluant une composante perpendiculaire au circuit imprimé 100. Par la suite, on appellera partie de transmission de mouvement la partie mobile parallèlement au circuit imprimé et partie mobile la partie mobile en translation selon un axe incluant une composante perpendiculaire au circuit imprimé. Autrement dit, la partie mobile du moyen de verrouillage peut se translater selon un axe perpendiculaire ou sensiblement perpendiculaire au circuit imprimé. La partie mobile du moyen de verrouillage expansible 101 dispose d'une surface supérieure 95 dans un plan parallèle au plan du circuit imprimé 100. De même, la partie mobile du moyen de verrouillage expansible 102 dispose d'une surface supérieure 96 dans un plan parallèle au plan du circuit imprimé 100. Le drain thermique 103 est disposé au dessus du circuit imprimé 100 parallèlement au circuit imprimé 100. Le drain thermique 103 vient en contact sur les moyens de verrouillage expansibles 101 et 102 au niveau des surfaces supérieures 95 et 96 de leur partie mobile respective. Le moyen de verrouillage expansible 101 est positionné dans une glissière 91 du châssis 104 recevant la carte électronique 20. De même, le moyen de verrouillage expansible 102 est positionné dans une glissière 92 du châssis 104 recevant la carte électronique 20. Le serrage de la carte électronique 20 et du drain thermique 103 dans les glissières 91 et 92 est assuré par les parties mobiles des moyens de verrouillage expansibles 101 et 102 qui se translatent selon l'axe 30 perpendiculaire au circuit imprimé. Ainsi, le drain thermique 103 est pressé contre une face 97 de la glissière 91 et une face 98 de la glissière 92. Le drain thermique 103 permet l'évacuation par conduction de la chaleur issue des composants 105 vers le châssis 104 représentant le milieu froid. Ce type de refroidissement est très avantageux puisqu'il permet d'avoir un système complètement hermétique. On peut par exemple noter que la poussière ne peut pas venir sur les pièces électroniques ainsi isolées de l'air environnant, ce qui n'est pas le cas du refroidissement pas convection. Néanmoins, le refroidissement par conduction nécessite une découpe des bords du circuit imprimé pour pouvoir placer les moyens de verrouillage expansibles 101 et 102. Autrement dit, selon le mode de refroidissement choisi, deux formats de circuits imprimés sont nécessaires.

La figure 4a représente en coupe dans un plan perpendiculaire au circuit imprimé et parallèle au fond de panier un exemple d'assemblage d'une carte électronique 22 comprenant un drain thermique 113, un circuit imprimé 110 et deux moyens de verrouillage expansibles 111 et 112 selon l'invention. Le drain thermique 113 est positionné sur le circuit imprimé 110 parallèlement au circuit imprimé 110. Le moyen de verrouillage expansible 111 est positionné le long d'un bord du circuit imprimé 110. Le moyen de verrouillage expansible 111 comprend une partie de transmission de mouvement, mobile parallèle au circuit imprimé 110, et une partie mobile en translation selon un axe 31 incluant une composante perpendiculaire au circuit imprimé.

La partie mobile en translation selon l'axe 31 du moyen de verrouillage expansible 111 est de forme allongée, s'étendant le long d'un bord du circuit imprimé 110. La partie mobile en translation selon l'axe 31 dispose d'une surface supérieure 135 dans un plan parallèle au plan du circuit imprimé 110. De même, la partie mobile du moyen de verrouillage expansible 112 dispose d'une surface supérieure 136 dans un plan parallèle au plan du circuit imprimé 110. Le drain thermique 113 est disposé au dessus de la carte électronique 22 parallèlement au circuit imprimé 110. Le drain thermique 113 épouse la forme des composants 115 et vient en contact sur les moyens de verrouillage expansibles 111 et 112 au niveau des surfaces supérieures 135 et 136 de leur partie mobile respective. Le moyen de verrouillage 111 est positionné dans une glissière 121 du châssis 104 recevant la carte électronique 22. La partie mobile du moyen de verrouillage 111 se translate selon l'axe 31 incluant une composante perpendiculaire au circuit imprimé 110, assurant le serrage de la carte électronique 22 et du drain thermique 113 dans la glissière 121 contre une face 137. Ainsi, le moyen de verrouillage expansible 111 immobilise la carte électronique 22 dans le châssis 104. De même, la partie mobile du moyen de verrouillage 112 se translate selon un axe 32 incluant une composante perpendiculaire au circuit imprimé 110, assurant le serrage de la carte électronique 22 et du drain thermique 113 dans la glissière 122 contre une face 138. Les moyens de verrouillages expansibles 111 et 112 permettent de presser le drain thermique 113 contre les faces 137 et 138 pour évacuer par conduction la chaleur produite par les composants 115 vers le châssis 104.

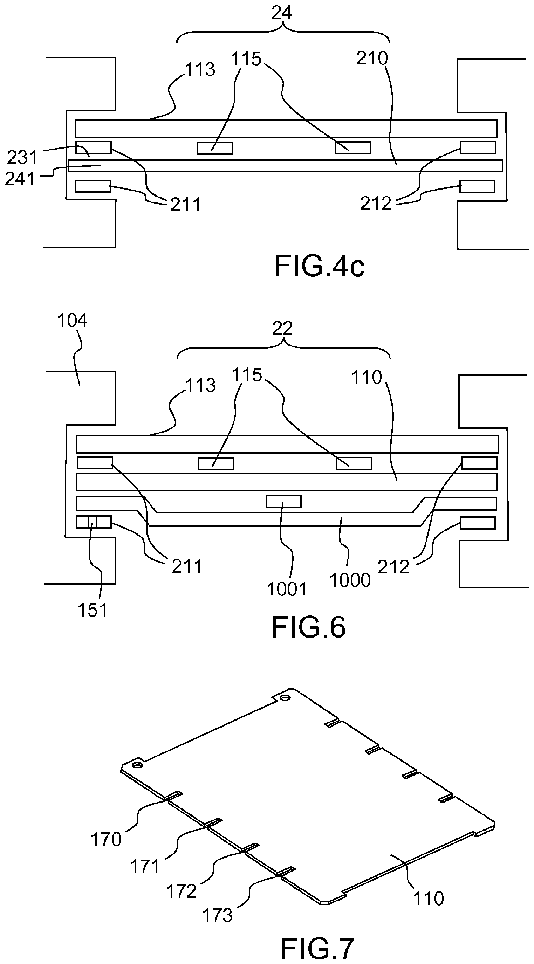

La partie mobile en translation selon l'axe 31 du moyen de verrouillage expansible 111 dispose d'une face 139 perpendiculaire au circuit imprimé 110. La partie mobile en translation selon l'axe 31 du moyen de verrouillage expansible 111 dispose d'au moins un évidement 131 s'ouvrant vers le circuit imprimé 110 sur la face 139. Le circuit imprimé comprend une zone 141 qui entre dans l'évidement 131 du moyen de verrouillage expansible 111. Autrement dit, l'évidement 131 peut recevoir la zone 141 du circuit imprimé 110. L'évidement 131 du moyen de verrouillage expansible 111 peut être borgne, comme représenté sur la figure 4a. La figure 4b est identique à la figure 4a. Il s'agit d'une représentation en coupe dans un plan perpendiculaire au circuit imprimé et parallèle au fond de panier d'un exemple d'assemblage de la carte électronique 22 avec le drain thermique 113, le circuit imprimé 110 et deux moyens de verrouillage 211 et 212 selon l'invention. Dans le cas de la figure 4b, le moyen de verrouillage 211 dispose d'un évidement 231 traversant. Enfin, la figure 4c est identique à la figure 4b. Il s'agit d'une représentation en coupe dans un plan perpendiculaire au circuit imprimé et parallèle au fond de panier d'un exemple d'assemblage d'une carte électronique 24 avec le drain thermique 113, un circuit imprimé 210 et deux moyens de verrouillage 211 et 212 selon l'invention. Dans le cas de la figure 4c, les moyens de verrouillage 211 et 212 disposent d'un évidement 231 traversant. Le circuit imprimé 210 comprend une zone 241 qui entre dans l'évidement 231 et dépasse de l'évidement 231. Autrement dit, la zone 241 du circuit imprimé qui entre dans l'évidement 231 du moyen de verrouillage expansible 211 peut complètement traverser le moyen de verrouillage expansible ajouré 211. Lorsque la zone 241 dépasse de l'évidement 231, il est alors possible de conserver une fonction de refroidissement par convection tout en utilisant une carte refroidie par conduction. En effet, la carte reste alors encastrable dans la glissière pour un refroidissement par convection au moyen d'une circulation d'air. Cette configuration est très avantageuse puisque les mêmes bancs de tests de carte en production, maintenance et réparation peuvent servir à la fois pour tester des cartes en refroidissement par convection et par conduction. Cette compatibilité est imposée par la norme IEEE1101.2.

Il est également possible de considérer dans le cadre de l'invention une zone 241 qui entre dans l'évidement 231 et dépasse de manière importante de l'évidement 231. Autrement dit, le moyen de verrouillage expansible ajouré 211 est positionné non pas au bord au circuit imprimé 210 mais dans une zone centrale du circuit imprimé 210.

Dans le cas d'un évidement 231 traversant, il est possible d'ajouter un appui thermique latéral supplémentaire dans la glissière du châssis. L'appui thermique latéral est perpendiculaire à l'appui thermique principal établi par le moyen de verrouillage expansible. L'appui thermique latéral peut être réalisé en faisant passer latéralement un conducteur thermique ou un caloduc dans l'évidement traversant du moyen de verrouillage expansible selon un axe sensiblement parallèle au circuit imprimé et au fond de panier.

Les zones 141 et 241 du circuit imprimé constituent une augmentation de surface du circuit imprimé par rapport à un circuit imprimé standard 100 (figure 3), c'est-à-dire ayant subi, ou ayant potentiellement à subir, une découpe de ses bords. L'augmentation de surface permet de mettre des pistes supplémentaires et éventuellement des composants. Le routage des pistes peut ainsi être simplifié, le nombre de couches constituant le circuit imprimé diminué, ce qui entraîne une diminution du coût du circuit imprimé.

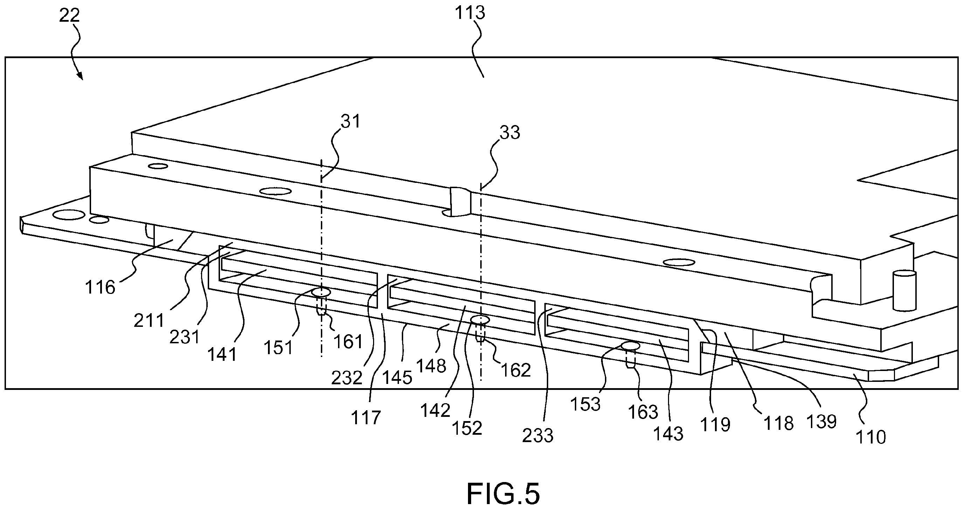

La figure 5 représente le positionnement de la carte électronique 22 et du drain thermique 113 par rapport au moyen de verrouillage 211 selon l'invention. Le circuit imprimé 110 comprend la zone 141 qui entre dans l'évidement 231 du moyen de verrouillage expansible 211. Le drain thermique 113 est positionné sur le circuit imprimé 110 et parallèle au plan du circuit imprimé 110. Le moyen de verrouillage expansible 211 comprend une partie de transmission de mouvement 116, mobile parallèlement au circuit imprimé 110, une partie mobile 117 qui se translate selon un axe 33 incluant une composante perpendiculaire au circuit imprimé 110 pour assurer le serrage du drain thermique 113 dans la glissière 121 (non représentée sur cette figure). Il existe plusieurs façons de générer le mouvement de translation de la partie mobile 117 selon un axe incluant une composante perpendiculaire au circuit imprimé 110, par exemple au moyen d'articulations ou de coins. Sur la figure 5, la translation de la partie mobile 117 se fait au moyen de coins. La partie mobile 117 dispose d'un coin 119 formé par un pan incliné par rapport au circuit imprimé 110. Un coin 118 mobile parallèlement au circuit imprimé 110 se translate vers le coin 119. En se translatant, le coin 118 entre en contact avec le coin 119 solidaire de la partie mobile 117 du moyen de verrouillage expansible 211. La partie mobile 117 se translate selon l'axe 33 incluant une composante perpendiculaire au circuit imprimé 110.

L'évidement 231 s'ouvre au niveau de la surface 139 de la partie mobile 117. La partie mobile 117 du moyen de verrouillage expansible 211 dispose de la surface inférieure 145 dans le plan parallèle au circuit imprimé 110. On définit une partie inférieure 148 de la partie mobile 117 contenant la surface 145. La partie inférieure 148 de la partie mobile 117 comprend un trou 151 traversant la partie inférieure 148, perpendiculairement à la surface 145. Le trou 151 est destiné à permettre le passage d'un moyen 161 de maintien du drain thermique 113 sur le circuit imprimé 110, sans devoir percer le circuit imprimé au niveau de la surface principale destinée à accueillir des composants. On peut appeler le trou 151 trou de maintien. De même, la partie inférieure 148 de la partie mobile 117 du moyen de verrouillage expansible 211 peut comprendre plusieurs autres trous de maintien 152, 153 pour permettre le passage de plusieurs moyens 162, 163 de maintien du drain thermique 113 sur le circuit imprimé 110. Le nombre, la taille et la forme des trous positionnés sur la surface 145 sont définis selon l'utilisation envisagée pour obtenir le meilleur compromis maintien/faisabilité/coût. Les trous de maintien du drain thermique sur le circuit imprimé, dans le cadre de l'invention, sont ainsi situés dans la partie latérale de la carte et n'empiètent pas sur la surface disponible de la carte pour les composants, comme ce serait le cas avec le procédé classique où les parties latérales sont découpées. La partie mobile 117 du moyen de verrouillage expansible 211 peut disposer de plusieurs évidements 232, 233 s'ouvrant sur la face 139 de la partie mobile 117. Dans ce cas, le circuit imprimé 110 peut disposer de zones 142 et 143 pour accueillir des composants et des pistes d'interconnexion. Les évidements 232 et 233 peuvent recevoir les zones 142, 143 du circuit imprimé 110.

La figure 6 représente en coupe un assemblage d'une carte électronique 22 avec son drain thermique 113, ses deux moyens de verrouillage 211 et 212. Tous ces éléments sont identiques à la figure 4b. La configuration représentée sur la figure 6 comprend de plus un drain secondaire 1000. Le trou de maintien 151 peut aussi servir à fixer le drain secondaire 1000 sur le dessous du circuit imprimé 110 afin d'évacuer la chaleur des composants 1001 et/ou pour assurer une protection électrostatique, sans occuper de surface du circuit imprimé destinée à accueillir des composants et/ou des pistes.

La figure 7 représente le circuit imprimé 110 selon l'invention. Le circuit imprimé 110 comprend deux encoches 170, 171 le long d'un bord destiné à entrer dans l'évidement 231 de la partie mobile 117 du moyen de verrouillage expansible 211. Les encoches 170 et 171 délimitent la zone 141 entrant dans l'évidement 231. Si on considère la figure 5 avec les trois zones 141, 142 et 143 du circuit imprimé 110 entrant dans les évidements 231, 232 et 233, le circuit imprimé 110 nécessite quatre encoches 170, 171, 172 et 173. Plus généralement, pour un moyen de verrouillage expansible à n évidements, le circuit imprimé a n+1 encoches. Le nombre n d'évidements du moyen de verrouillage résulte d'un compromis entre la mise en position de la carte électronique 22 et de la robustesse de l'assemblage. L'invention permet de disposer d'un circuit imprimé unique compatible d'un refroidissement par convection et par conduction, sans devoir procéder à une redécoupe de la carte pour convertir une carte assemblée avec ses composants électroniques du mode refroidissement par convection au mode refroidissement par conduction. Quelque soit le type de refroidissement envisagé ultérieurement, un seul type de circuit imprimé est fabriqué et stocké. Une fois le circuit imprimé assemblé, il n'est pas nécessaire de le ré-usiner pour passer d'un circuit en refroidissement par convection à un circuit en refroidissement par conduction. L'opération inverse est tout à fait envisageable. On peut souhaiter passer d'un circuit en refroidissement par conduction à un circuit en refroidissement par convection. Cela peut être le cas si un tri plus sévère en température existe pour un circuit en refroidissement par conduction. Les cartes assemblées qui échouent au tri peuvent être alors utilisées pour un refroidissement en convection pour lequel la gamme de température est généralement moins sévère.

## Revendications

1. Carte électronique (22 ; 24) comprenant :
• un circuit imprimé plan (110 ; 210),
• un drain thermique (113) positionné sur le circuit imprimé (110 ; 210) parallèlement au circuit imprimé (110 ; 210),
• un moyen de verrouillage expansible (111, 112 ; 211, 212) positionné le long d'un bord du circuit imprimé (110 ; 210) comprenant une partie de transmission de mouvement (116, 118) et une partie mobile en translation (117) selon un axe (31, 32, 33) incluant une composante perpendiculaire au circuit imprimé (110 ; 210), la partie mobile en translation (117) disposant d'au moins un évidement (131 ; 231, 232, 233) s'ouvrant sur une face (139) du moyen de verrouillage expansible (111, 112 ; 211, 212) perpendiculaire au circuit imprimé (110 ; 210),
le moyen de verrouillage (111, 112 ; 211, 212) étant destiné à immobiliser la carte (22 ; 24) dans un châssis (104) et à presser le drain thermique (113) contre une face du châssis (104),
**caractérisée en ce que** le circuit imprimé (110 ; 210) comprend une zone (141, 142, 143 ; 241) qui entre dans le ou les évidements (131 ; 231, 232, 233) du moyen de verrouillage expansible (111, 112 ; 211, 212).

2. Carte électronique (22 ; 24) selon la revendication 1, **caractérisée en ce que** la partie mobile (117) est de forme allongée s'étendant le long d'un bord du circuit imprimé (110 ; 210), comprenant une face (139) perpendiculaire au circuit imprimé (110 ; 210), le ou les évidements (131 ; 231, 232, 233) s'ouvrant sur la face (139) perpendiculaire au circuit imprimé (110 ; 210) de façon à recevoir la zone (141, 142, 143 ; 241) du circuit imprimé (110 ; 210).

3. Carte électronique (22) selon l'une des revendications précédentes, **caractérisée en ce que** l'évidement (131) de la partie mobile (117) du moyen de verrouillage (111, 112) est borgne.

4. Carte électronique (22) selon l'une des revendications précédentes, **caractérisée en ce que** l'évidement (231, 232, 233) de la partie mobile (117) du moyen de verrouillage (211, 212) est traversant.

5. Carte électronique (24) selon la revendication 4, **caractérisée en ce que** la zone (241) du circuit imprimé (210) qui entre dans les évidements (231, 232, 233) du moyen de verrouillage (211, 212) dépasse des évidements (231, 232, 233) du moyen de verrouillage (211, 212).

6. Carte électronique (22) selon l'une des revendications précédentes, **caractérisée en ce que** la partie mobile (117) du moyen expansible (211, 212) comprend une partie inférieure (148) comprenant au moins un trou (151, 152, 153) traversant la partie inférieure (148), le trou (151, 152, 153) étant destiné à permettre le passage d'un moyen de maintien (161, 162, 163) du drain thermique (113) sur le circuit imprimé (110).

7. Carte électronique (22) selon l'une des revendications précédentes, **caractérisée en ce que** la partie mobile (117) du moyen de verrouillage (211, 212) dispose de plusieurs évidements (231, 232, 233) s'ouvrant sur la face perpendiculaire (139) au circuit imprimé.

8. Carte électronique (22) selon la revendication 7, **caractérisée en ce que** le circuit imprimé (110 ; 210) comprend des encoches (170, 171, 172, 173) le long d'un bord destiné à entrer dans les évidements (131 ; 231, 232, 233) de la partie mobile (117) du moyen de verrouillage (111, 112 ; 211, 212), les encoches (170, 171, 172, 173) délimitant les zones (141, 142, 143 ; 241) entrant dans le ou les évidements (131 ; 231, 232, 233).

## Patentansprüche

1. Elektronische Karte (22; 24), welche Folgendes beinhaltet:
• eine ebene Leiterplatte (110; 210),
• eine Wärmesenke (113), welche auf der Leiterplatte (110; 210) parallel zur Leiterplatte (110; 210) positioniert ist,
• ein expandierbares Verriegelungsmittel (111, 112; 211, 212), welches entlang eines Randes der Leiterplatte (110; 210) positioniert ist, welches einen Bewegungsübertragungsteil (116, 118) und einen verschiebbaren Teil (117) entlang einer Achse (31, 32, 33) beinhaltet, welcher eine zur Leiterplatte rechtwinklige Komponente (110; 210) enthält, wobei der verschiebbare Teil (17) über mindestens eine Aussparung (131; 231, 232, 233) verfügt, welche auf eine Seite (139) des expandierbaren Verriegelungsmittels (111, 112; 211, 212) mündet, welches rechtwinklig zur Leiterplatte (110; 210) ist,
das Verriegelungsmittel (111, 112; 211, 212), welches dazu bestimmt ist, die Karte (22 24) in einem Gestell (104) zu fixieren und die Wärmesenke (113) gegen eine Seite des Gestells (104) zu drücken,
**dadurch gekennzeichnet, dass** die Leiterplatte (110; 210) einen Bereich (141, 142, 143; 241) beinhaltet, welcher in die Aussparung(en) (131; 231, 232, 233) des expandierbaren Verriegelungsmittels (111, 112; 211, 212) eintritt.

2. Elektronische Karte (22 24) nach Anspruch 1, **dadurch gekennzeichnet, dass** der bewegliche Teil (117) eine längliche Form besitzt, welche sich entlang eines Randes der Leiterplatte (110; 210) erstreckt, welcher eine zur Leiterplatte (110; 210) rechtwinklige Seite (139) beinhaltet, wobei die Aussparung(en) (131; 231, 232, 233) auf diejenige Seite (139) mündet/münden, welche rechtwinklig zur Leiterplatte (110; 210) ist, um den Bereich (141, 142, 143; 241) der Leiterplatte (110; 210) aufzunehmen.

3. Elektronische Karte (22) nach einem der vorhergehenden Ansprüche, **dadurch gekennzeichnet, dass** die Aussparung (131) des beweglichen Teils (117) des Verriegelungsmittels (111, 112) ein Sackloch ist.

4. Elektronische Karte (22) nach einem der vorhergehenden Ansprüche, **dadurch gekennzeichnet, dass** die Aussparung (231, 232, 233) des beweglichen Teils (117) des Verriegelungsmittels (211, 212) ein Durchgangsloch ist.

5. Elektronische Karte (24) nach Anspruch 4, **dadurch gekennzeichnet, dass** der Bereich (241) der Leiterplatte (210), welcher in die Aussparungen (231, 232, 233) des Verriegelungsmittels (211, 212) eintritt, die Aussparungen (231, 232, 233) des Verriegelungsmittels (211, 212) überragt.

6. Elektronische Karte (22) nach einem der vorhergehenden Ansprüche, **dadurch gekennzeichnet, dass** der bewegliche Teil (117) des expandierbaren Mittels (211, 212) einen unteren Teil (148) beinhaltet, welcher mindestens ein Loch (151, 152, 153) beinhaltet, welches den unteren Teil (148) durchquert, wobei das Loch (151, 152, 153) dazu bestimmt ist, den Durchgang eines Haltemittels (161, 162, 163) der Wärmesenke (113) an der Leiterplatte (110) zu ermöglichen.

7. Elektronische Karte (22) nach einem der vorhergehenden Ansprüche, **dadurch gekennzeichnet, dass** der bewegliche Teil (117) des Verriegelungsmittels (211, 212) über mehrere Aussparungen (231, 232, 233) verfügt, welche auf diejenige Seite (139) münden, welche rechtwinklig zur Leiterplatte ist.

8. Elektronische Karte (22) nach Anspruch 7, **dadurch gekennzeichnet, dass** die Leiterplatte (110; 210) Einkerbungen (170, 171, 172, 173) entlang eines Randes beinhaltet, welcher dazu bestimmt ist, in die Aussparungen (131; 231, 232, 233) des beweglichen Teils (117) des Verriegelungsmittels (111, 112; 211, 212) einzutreten, wobei die Einkerbungen (170, 171, 172, 173) diejenigen Bereiche (141, 142, 143; 241) abgrenzen, welche in die Aussparung(en) (131; 231, 232, 233) eintreten.

## Claims

1. Electronic board (22; 24) comprising:
• a plane printed circuit (110; 210),
• a thermal drain (113) positioned on the printed circuit (110; 210) parallel to the printed circuit (110; 210),
• an expandable locking means (111, 112; 211, 212) positioned along one edge of the printed circuit (110; 210) comprising a part for transmission of movement (116, 118) and a part mobile in translation (117) along an axis (31, 32, 33) including a component perpendicular to the printed circuit (110; 210), the part mobile in translation (117) disposing of at least one recess (131; 231, 232, 233) opening onto a face (139) of the expandable locking means (111, 112; 211, 212) perpendicular to the printed circuit (110; 210),
the locking means (111, 112; 211, 212) being designed to rigidly fix the board (22; 24) in a chassis (104) and to press the thermal drain (113) against a face of the chassis (104),
**characterized in that** the printed circuit (110; 210) comprises a region (141, 142, 143; 241) which enters into the recess or recesses (131; 231, 232, 233) of the expandable locking means (111, 112; 211, 212).

2. Electronic board (22; 24) according to Claim 1, **characterized in that** the mobile part (117) has an elongated shape running along one edge of the printed circuit (110; 210), comprising a face (139) perpendicular to the printed circuit (110; 210), the recess or recesses (131; 231, 232, 233) opening onto the face (139) perpendicular to the printed circuit (110; 210) so as to receive the region (141, 142, 143; 241) of the printed circuit (110; 210).

3. Electronic board (22) according to one of the preceding claims, **characterized in that** the recess (131) of the mobile part (117) of the locking means (111, 112) is a blind recess.

4. Electronic board (22) according to one of the preceding claims, **characterized in that** the recess (231, 232, 233) of the mobile part (117) of the locking means (211, 212) is a through-recess.

5. Electronic board (24) according to Claim 4, **characterized in that** the region (241) of the printed circuit (210) which enters into the recesses (231, 232, 233) of the locking means (211, 212) protrudes from the recesses (231, 232, 233) of the locking means (211, 212).

6. Electronic board (22) according to one of the preceding claims, **characterized in that** the mobile part (117) of the expandable means (211, 212) comprises a lower part (148) comprising at least one hole (151, 152, 153) passing through the lower part (148), the hole (151, 152, 153) being designed to allow the passage of a means (161, 162, 163) for retaining the thermal drain (113) on the printed circuit (110).

7. Electronic board (22) according to one of the preceding claims, **characterized in that** the mobile part (117) of the locking means (211, 212) has several recesses (231, 232, 233) opening onto the face perpendicular (139) to the printed circuit.

8. Electronic board (22) according to Claim 7, **characterized in that** the printed circuit (110; 210) comprises notches (170, 171, 172, 173) along one edge designed to fit into the recesses (131; 231, 232, 233) of the mobile part (117) of the locking means (111, 112; 211, 212), the notches (170, 171, 172, 173) bounding the regions (141, 142, 143; 241) entering into the recess or recesses (131; 231, 232, 233).
